# EUROPÄISCHE PATENTANMELDUNG

(11) **EP 1 623 885 A2**
(43) Veröffentlichungstag der Anmeldung: **08.02.2006**
(21) Anmeldenummer: 05014166.2
(22) Anmeldetag: 30.06.2005
(51) Int. Cl.: B60R 21/20, B60R 16/02, H05K 3/18

(54) **Gassackmodul**

(30) Priorität: 03.08.2004 DE 102004037462; 18.08.2004 DE 202004012964 U
(71) Anmelder: TRW Automotive Safety Systems GmbH, 63743 Aschaffenburg (DE)
(72) Erfinder: Helmstetter, Matthias, 63743 Aschaffenburg (DE); Hirzmann, Guido, 63877 Sailauf (DE)
(74) Vertreter: Sulzbach, Werner

(57) **Zusammenfassung**

Ein Gassackmodul (10) zur Verwendung in einer Fahrzeuginsassen-Rüchalteeinrichtung umfaßt einen aus Kunststoff gebildeten Generatorträger (12). Auf dem Generatorträger (12) ist eine durch Abscheiden von Metall gebildete gedruckte Schaltung (24) vorgesehen, die zur Auslösung eines elektrischen Funktionselements mit einem auf einem Abschnitt (22) des Generatorträgers (12) angeordneten Schaltelement (28) zusammenwirkt. Ein Verfahren zur Herstellung des Gassackmoduls (10) umfaßt das Vorbehandeln eines vorbestimmten Bereichs der Oberfläche des Gasgeneratorträgers (12) zur Erzeugung einer Oberflächenrauhigkeit sowie das elektrolytische Abscheiden von Metall auf der vorbehandelten Oberfläche unter Bildung einer gedruckten Schaltung (24).

## Beschreibung

Die Erfindung betrifft ein Gassackmodul zur Verwendung in einer Fahrzeuginsassen-Rückhalteeinrichtung mit einem aus Kunststoff gebildeten Generatorträger.

Gassackmodule sind ein Bestandteil von Fahrzeuginsassen-Rückhaltesystemen und können zum Schutz des Fahrers beispielsweise im Lenkrad angeordnet sein. Wegen des Bedarfs an Bauraum für das Gassackmodul ergeben sich aber Probleme bezüglich der räumlichen Anordnung der Verkabelung und der Kontakte für die Auslösung elektrischer Funktionselemente, wie beispielsweise einer elektrischen Hupe. Darüber hinaus sollen Bedienungselemente und Schalter zur Steuerung der Fahrzeugfunktionen für den Fahrer gut erreichbar am oder im Lenkrad angeordnet und nach Möglichkeit als Multifunktionselemente ausgebildet sein. Damit steigt aber ebenfalls die Anzahl und der Platzbedarf für die Kabel zum Anschluß der Bedienelemente an die Fahrzeugelektronik.

Nach dem sogenannten "Floating Horn"-Prinzip werden die Gassackmodule so an dem Lenkrad angeordnet, daß durch einen von dem Fahrer ausgeübten Druck auf das Gassackmodul das Hornsignal auslösbar ist. An dem Gassackmodul und dem Lenkrad ist dabei jeweils ein Kontakt angeordnet, und das Gassackmodul ist über elastische Distanzelemente mit dem Lenkrad verbunden. Dadurch können die Kontakte bei einem auf das Gassackmodul ausgeübten Druck durch eine Bewegung des Gassackmoduls zum Lenkrad hin kurzgeschlossen und so das Horn oder ein anderes elektrisches Funktionselement ausgelöst werden.

Aus der DE 199 27 032 A1 ist eine nach diesem Prinzip arbeitende Baugruppe mit einem Lenkrad und einem Gassackmodul bekannt. Das Gassackmodul umfaßt einen im Spritzgußverfahren aus Kunststoff hergestellten Generatorträger, in den ein Drahtelement eingespritzt ist. Das Drahtelement hat bügelförmige Abschnitte, die zur elektrischen Isolation mit Kunststoffbuchsen versehen sind, und die zur Befestigung des Gassackmoduls in am Lenkrad angeordnete Rasthaken eingreifen. Der Generatorträger weist ferner eine oder mehrere Aussparungen auf, in denen das Drahtelement zugänglich und nicht elektrisch isoliert ist. In diesen Aussparungen bildet das Drahtelement einen Kontakt für die Hornauslösung, der mit einem elektrisch leitenden Gegenkontakt am Lenkrad zusammenwirkt. Wenn der Kontakt mit dem Gegenkontakt durch einen Druck auf das Gassackmodul zum Lenkrad hin kurzgeschlossen wird, wird das elektrische Horn ausgelöst.

Die Erfindung schafft demgegenüber ein Gassackmodul, das einfach aufgebaut ist und die Integration von Multifunktionselementen und -schaltern ohne zusätzliche Bauteile und Kabelzuführungen gestattet. Das erfindungsgemäße Gassackmodul zur Verwendung in einer Fahrzeuginsassenrückhalteeinrichtung mit einem aus Kunststoff gebildeten Generatorträger ist dadurch gekennzeichnet, daß auf dem Generatorträger eine durch Abscheiden von Metall gebildete gedruckte Schaltung vorgesehen und die gedruckte Schaltung zur Auslösung eines elektrischen Funktionselements mit einem auf einem Abschnitt des Generatorträgers angeordneten Schaltelement zusammenwirkt.

Der Generatorträger des erfindungsgemäßen Gassackmoduls kann somit auf einfache Weise als dreidimensionaler spritzgegossener Schaltungsträger ausgebildet sein. Damit stehen eine Vielzahl von bekannten und kostengünstigen Herstellungsverfahren zur Verfügung. Die auf dem Generatorträger ausgebildeten Leiterbahnen der gedruckten Schaltung übernehmen die Funktion der herkömmlichen Verkabelung. Damit kann einerseits eine Gewichtsreduzierung erreicht werden, und andererseits wird der für die üblichen Kabelzuführungen und Steckverbindungen benötigte Bauraum eingespart. Zur Verbindung der auf den Generatorträger aufgebrachten gedruckten Schaltung mit der Fahrzeugelektronik wird nur eine einzige Steckerplatine benötigt, wodurch die Verlegung der Kabel im Lenkrad wesentlich vereinfacht wird. An die gedruckte Schaltung auf dem Generatorträger lassen sich verschiedene Schaltelemente zur Auslösung elektrischer Funktionselemente anschließen, die durch die Anordnung im Lenkrad für den Fahrer bequem erreichbar sind.

Schließlich ermöglicht die Erfindung, den Aufbau der in das Lenkrad integrierten Multifunktionsschalter zusätzlich zu vereinfachen, da der ohnehin vorhandene Generatorträger als Boden für die Schaltelemente verwendet werden kann. Damit wird ein einfacher und kostengünstiger Aufbau eines in das Lenkrad integrierten Multifunktionsschalters erreicht.

Als Deckel für den Multifunktionsschalter bzw. das auf dem mit der gedruckten Schaltung versehenen Abschnitt des Generatorträgers angeordnete Schaltelement kann eine separate Blende verwendet werden. Besonders vorteilhaft ist aber in die Abdeckung des Gassackmoduls wenigstens eine Öffnung oder ein Durchbruch eingebracht, in der ein Betätigungsabschnitt des Schaltelements aufgenommen ist. Die Abdeckung bildet dann in vorteilhafter Weise unter Einsparung eines weiteren Bauteils gleichzeitig den Deckel des Multifunktionsschalters. Das Schaltelement selbst kann in bekannter Weise als Silikonschaltmatte ausgebildet sein. Des weiteren kann das Schaltelement eine an die gedruckte Schaltung angeschlossene herkömmliche Platine umfassen.

Zur Auslösung eines elektrischen Funktionselements, beispielsweise einer elektrischen Hupe, wird das Schaltelement bevorzugt mit einem Kontaktabschnitt auf der gedruckten Schaltung in Kontakt gebracht. Der Kontaktabschnitt kann vorzugsweise durch zwei benachbarte und elektrisch voneinander isolierte Abschnitte der gedruckten Schaltung gebildet sein, die zur Auslösung des elektrischen Funktionselements durch das Schaltelement überbrückt und damit zusammengeschlossen werden.

In einer Variante des erfindungsgemäßen Gassackmoduls ist auf dem aus Kunststoff gebildeten Generatorträger eine durch Abscheiden von Metall gebildete gedruckte Schaltung vorgesehen, die zur Auslösung eines elektrischen Funktionselements, beispielsweise einer elektrischen Hupe, mit einem in einem vorbestimmten Abstand zu einem Kontaktabschnitt der gedruckten Schaltung angeordneten Schaltelement zusammenwirkt. Besonders bevorzugt weist dabei das Gassackmodul nach dem "Floating Horn"-Prinzip elastische Distanzelemente auf, durch die ein definierter Abstand zwischen dem Abschnitt der gedruckten Schaltung und dem in einfacher Weise als Gegenkontakt ausgebildeten Schaltelement eingestellt wird. Durch einen Druck auf die Abdeckung des Gassackmoduls wird der bevorzugt durch zwei benachbarte und voneinander elektrisch isolierte Leiterbahnen gebildete Kontaktabschnitt durch den beispielsweise als metallisierte Fläche ausgebildeten Gegenkontakt überbrückt und kurzgeschlossen und so das elektrische Funktionselement bzw. die Hupe ausgelöst.

Der Anschluß der gedruckten Schaltung und damit die Verbindung der verschiedenen an die gedruckte Schaltung angeschlossenen Multifunktionsschalter mit der Fahrzeugelektronik kann über eine einfache aufgelötete Steckverbindung erfolgen. Die Verkabelung der jeweiligen Schaltelemente mit der Fahrzeugelektronik ist dadurch wesentlich erleichtert.

Die Herstellung des Generatorträgers als sogenanntes "MID"-Bauteil, das heißt einem spritzgegossenen Schaltungsträger, kann nach verschiedenen Verfahren erfolgen. Bevorzugt ist der Generatorträger in einem Einkomponenten-Spritzgußverfahren aus einer thermoplastischen Kunststoffmatrix hergestellt, die einen in die Kunststoffmatrix eingebetteten Metallkomplex aufweist. Die thermoplastische Kunststoffmatrix kann insbesondere aus der aus Polyamid, Polyethylenterephthalat, Polybutylenterephthalat, Acrylnitril-Butadien-Styrol, Polypropylen, Polycarbonat und Polyetherimid bestehenden Gruppe ausgewählt sein. Der auf diese Weise in einem Spritzgußverfahren bereitgestellte Generatorträger wird dann in einem ersten Schritt durch bildmäßiges Belichten mit einem Laser vorbehandelt. Durch die Laserbehandlung wird in einem vorbestimmten Bereich eine Oberflächenrauhigkeit erzeugt, so daß damit Hinterschneidungen für das Verklammern der später aufgebrachten Metallschicht entstehen. Die Laserbehandlung führt ferner zu einer Zersetzung des in die Kunststoffmatrix eingebetteten Metallkomplex unter Ausbildung metallisierbarer Keime. Der so vorbehandelte Generatorträger wird anschließend in bekannter Weise einer außenstromlosen Metallabscheidung unterzogen. Hierzu wird der Generatorträger in ein Bad aus einer Metallsalzlösung, beispielsweise einem Nickel- oder Kupfersalz, und einem Reduktionsmittel eingetaucht. Auf den durch die Laserstrukturierung vorbehandelten Abschnitten des Generatorträgers bildet sich auf diese Weise eine leitfähige Metallschicht, während die nicht behandelten Abschnitte der Generatorträgeroberfläche metallfrei und damit elektrisch isolierend bleiben. Die so gebildete Metallschicht kann anschließend durch eine elektrolytische Metallabscheidung in einer galvanischen Zelle unter Bildung der gedruckten Schaltung verstärkt werden. Ähnlich wie bei der Herstellung üblicher Leiterplatten ist mit diesem Verfahren auch die Bildung von metallisierten Durchgangslöchern in der gedruckten Schaltung auf dem Generatorträger möglich.

Anstelle des hier beschriebenen Verfahrens der Laserstrukturierung können andere bekannte Verfahren zur Erzeugung gemusterter Oberflächen, wie beispielsweise ein chemisches Ätzen oder Plasmaätzen verwendet werden. Schließlich sind auch die herkömmlichen Siebdruck- oder Tampondruckverfahren zur Herstellung gedruckter Schaltungen einsetzbar. Der Generatorträger kann dann mit einem beliebigen Spritzgußverfahren, als Ein- oder Zweikomponentenbauteil, hergestellt werden.

Weitere Vorteile der vorliegenden Erfindung ergeben sich aus der nachfolgenden Beschreibung einer bevorzugten Ausführungsform mit Bezug auf die beigefügte Zeichnung. In der Zeichnung zeigen:
- Figur 1 eine Draufsicht auf einen Generatorträger des erfindungsgemäßen Gassackmoduls;
- Figur 2 eine Detailansicht des Generatorträgers aus Figur 1 mit zugehörigem Schaltelement;
- Figur 3 eine Schnittansicht einer Ausführungsform des erfindungsgemäßen Gassackmoduls;
- Figur 4 eine Abdeckung gemäß einer Ausführungsform des erfindungsgemäßen Gassackmoduls; und
- Figur 5 eine Draufsicht auf die Unterseite des Generatorträgers aus Figur 1.

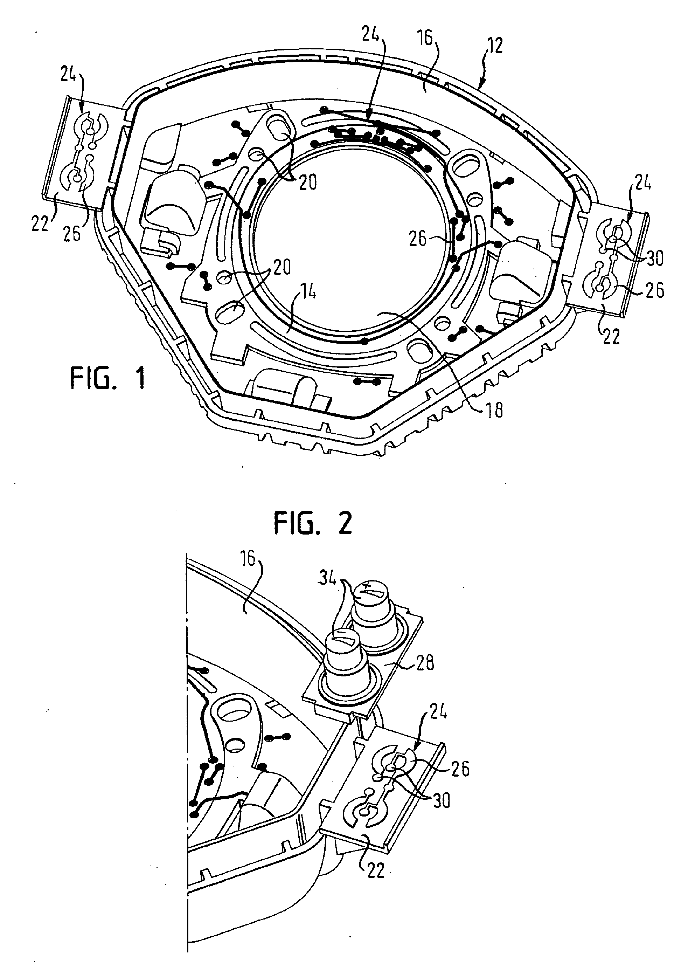

Figur 1 zeigt den Generatorträger 12 eines Gassackmoduls (hier nicht dargestellt), das zum Einbau in das Lenkrad eines Kraftfahrzeugs vorgesehen ist. Der Generatorträger 12 ist in einem Spritzgußverfahren aus Kunststoff hergestellt. Er hat einen im allgemeinen topfförmigen Aufbau mit einem Boden 14 und einer vom Boden 14 ausgehenden umlaufenden Seitenwand 16. Der Boden 14 weist eine zentrale Öffnung 18 zur Aufnahme eines Gasgenerators (nicht gezeigt) auf. Darüber hinaus sind in den Boden weitere Öffnungen 20 eingebracht, die beispielsweise zur Befestigung des Gasgenerators am Generatorträger 12 dienen.

An zwei gegenüberliegenden Positionen der Seitenwand 16 ist jeweils ein plattenförmiger, nach außen gerichteter Abschnitt 22 angeformt. Auf dem Boden 14 ist eine durch Abscheiden von Metall gebildete gedruckte Schaltung 24 mit Leiterbahnen 26 aufgebracht, die sich auch auf den plattenförmigen Abschnitt 22 erstreckt.

Wie in Figur 2 im Detail gezeigt ist, dient der plattenförmige Abschnitt 22 mit den darauf aufgebrachten Leiterbahnen 26 der gedruckten Schaltung 24 als Boden für ein Schaltelement 28, das bevorzugt als Silikonschaltmatte mit darauf aufgesetzten Betätigungsabschnitten 34 ausgebildet ist. Das Schaltelement 28 wird auf den plattenförmigen Abschnitt 22 aufgesetzt und wirkt dann mit den Leiterbahnen 26 der gedruckten Schaltung 24 auf dem Abschnitt 22 zur Auslösung eines elektrischen Funktionselements (hier nicht gezeigt) zusammen. Insbesondere können die Leiterbahnen 26 einander benachbarte und elektrisch voneinander isolierte Kontaktabschnitte 30 umfassen, die zur Auslösung des elektrischen Funktionselements durch einen Druck auf die Betätigungsabschnitte 34 des Schaltelements 28 überbrückbar sind.

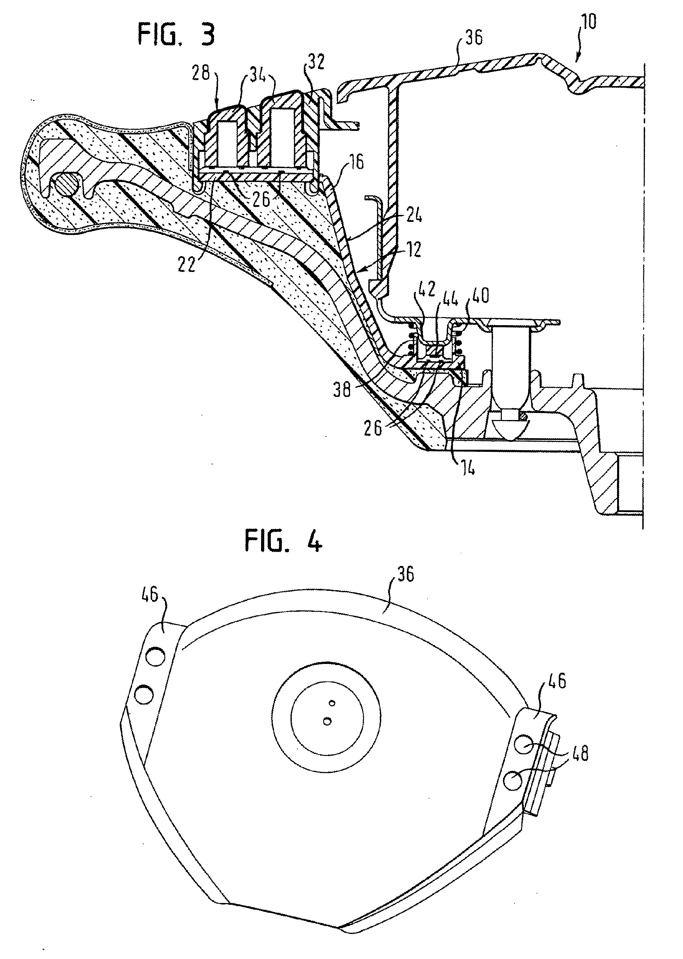

Bei der in Figur 3 gezeigten Ausführungsform umfaßt das Gassackmodul 10 den topfförmigen Generatorträger 12 mit dem im wesentlichen ebenen Boden 14 und der randseitig umlaufenden Seitenwand 16. Am freien Ende der Seitenwand 16 ist der nach außen gerichtete plattenförmige Abschnitt 22 angeformt. Auf dem Generatorträger 12 und dem plattenförmigen Abschnitt 22 ist durch Abscheiden von Metall die gedruckte Schaltung 24 mit Leiterbahnen 26 gebildet. Die Leiterbahnen 26 wirken mit dem Schaltelement 28 zusammen, das auf dem plattenförmigen Abschnitt 22 aufgesetzt ist. Mit einer Blende 32, die auf das Schaltelement 28 aufgeclipst ist, wird das Schaltelement 28 auf dem plattenförmigen Abschnitt 22 fixiert. Die Betätigungsabschnitte 34 des Schaltelements 28 sind über entsprechende Öffnungen in der Blende 32 für den Fahrer gut zugänglich. Das Schaltelement 28, die Blende 32 und der plattenförmige Abschnitt 22 des Generatorträgers 12 bilden somit einen einfach aufgebauten und durch die Integration in das Lenkrad für den Fahrer gut erreichbaren Multifunktionsschalter.

Das Gassackmodul 10 umfaßt weiter eine mit dem Generatorträger 12 elastisch verbundene Abdeckung 36. Hierzu weist der Boden 14 des Generatorträgers 12 ein im wesentlichen rohrförmiges Ansatzstück 38 auf, welches einwärts in das Gassackmodul 10 hineinragt und auf das eine Spiralfeder 40 aufgesetzt ist. An ihrem gegenüberliegenden Ende umgreift die Spiralfeder 40 einen napfförmigen Ansatz 42 im Boden des Gassackmoduls 10. Auf diese Weise definiert die Spiralfeder 40 als elastisches Distanzelement einen vorbestimmten Abstand zwischen dem Boden 14 und dem napfförmigen Ansatz 42.

Im Bereich des rohrförmigen Ansatzstücks 38 sind auf dem Boden 14 einander benachbarte und elektrisch voneinander isolierte Kontaktabschnitte 30 der gedruckten Schaltung 24 ausgebildet. Gegenüber den Kontaktabschnitten 30 liegt der napfförmige Ansatz 42, der als Schaltelement dient und entweder aus Metall gebildet sein kann oder eine metallisierte Kontaktfläche 44 aufweist. Diese Kontaktfläche 44 bildet einen Gegenkontakt zu den Kontaktabschnitten 30 der gedruckten Schaltung 24. Durch einen Druck auf die Abdeckung 36 in Richtung auf das Lenkrad wird die Spiralfeder 40 zusammengedrückt und die metallisierte Kontaktfläche 44 kommt in elektrischen Kontakt mit den Leiterbahnen 26. Diese werden überbrückt und zusammengeschlossen, und so das elektrische Funktionselement, beispielsweise eine Hupe, eingeschaltet.

In Figur 4 ist eine Abdeckung 36 eines Gassackmoduls gezeigt, bei der randseitige Abschnitte 46 mit Öffnungen 48 versehen sind. In diesen Öffnungen 48 können die Betätigungsabschnitte 34 des in Figur 2 dargestellten Schaltelements 28 aufgenommen werden. Die Abdeckung 36 ersetzt somit auch die Blende 32 der in Figur 3 gezeigten Ausführungsform. Damit kann eine weitere Reduzierung der Schalterbauteile erreicht werden.

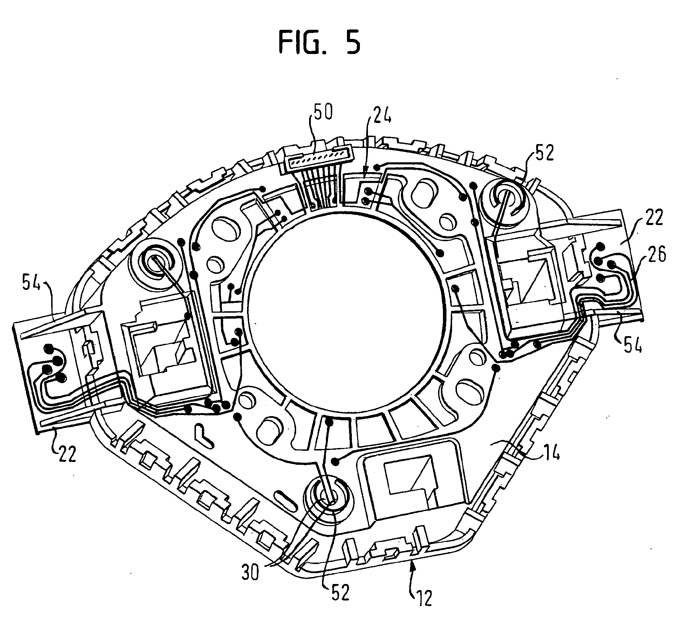

In Figur 5 ist schließlich gezeigt, daß auch die Unterseite des Generatorträgers 12, wie oben beschrieben, mit einer gedruckten Schaltung 24 versehen sein kann. Die gedruckte Schaltung 24 ist an eine Steckverbindung 50 angeschlossen, mit der in einfacher Weise eine Verbindung mit der Fahrzeugelektronik hergestellt werden kann. Die gedruckte Schaltung 24 übernimmt die Aufgabe von Kabelzuführungen, beispielsweise zu den Hupenkontakten 52, die einander benachbarte und elektrisch voneinander isolierte Kontaktabschnitte 30 der Leiterbahnen 26 umfassen. Des weiteren erstrecken sich die Leiterbahnen 26 hin zu den plattenförmigen Abschnitten 22, wo sie mit dem oder den Schaltelementen 28 (Figur 2) zusammenwirken. Die plattenförmigen Abschnitte 22 können durch an ihre Unterseite angeordnete Stege oder Rippen 54 zusätzlich mechanisch verstärkt sein.

## Patentansprüche

1. Gassackmodul (10) zur Verwendung in einer Fahrzeuginsassen-Rückhalteeinrichtung mit einem aus Kunststoff gebildeten Generatorträger (12), **dadurch gekennzeichnet, daß** auf dem Generatorträger (12) eine durch Abscheiden von Metall gebildete gedruckte Schaltung (24) vorgesehen ist und die gedruckte Schaltung (24) zur Auslösung eines elektrischen Funktionselements mit einem auf einem Abschnitt (22) des Generatorträgers (12) angeordneten Schaltelement (28) zusammenwirkt.

2. Gassackmodul nach Anspruch 1, **dadurch gekennzeichnet, daß** das Schaltelement (28) elektrisch an die gedruckte Schaltung (24) angeschlossen ist.

3. Gassackmodul nach Anspruch 1 oder 2, **dadurch gekennzeichnet, daß** das Schaltelement (28) einen Betätigungsabschnitt (34) und das Gassackmodul (10) eine mit dem Generatorträger (12) verbundene Abdeckung (36) umfaßt, wobei die Abdeckung (36) wenigstens eine Öffnung (38) aufweist, in der der Betätigungsabschnitt (28) aufgenommen ist.

4. Gassackmodul nach Anspruch 1 oder 2, **dadurch gekennzeichnet, daß** das Schaltelement (28) mit einer separaten Blende (32) versehen ist.

5. Gassackmodul nach einem der Ansprüche 1 bis 4, **dadurch gekennzeichnet, daß** das Schaltelement (28) als Silikonschaltmatte ausgebildet ist.

6. Gassackmodul nach einem der Ansprüche 1 bis 5, **dadurch gekennzeichnet, daß** das Schaltelement (28) eine an die gedruckte Schaltung (24) angeschlossene Platine umfaßt.

7. Gassackmodul nach einem der Ansprüche 1 bis 6, **dadurch gekennzeichnet, daß** die gedruckte Schaltung (24) einen Kontaktabschnitt (30) aufweist und das Schaltelement (28) mit dem Kontaktabschnitt (30) in Kontakt gebracht wird.

8. Gassackmodul nach Anspruch 7, **dadurch gekennzeichnet, daß** der Kontaktabschnitt (30) durch zwei benachbarte und elektrisch voneinander isolierte Abschnitte der gedruckten Schaltung (24) gebildet ist, die zur Auslösung des elektrischen Funktionselements durch das Schaltelement (28) überbrückbar sind.

9. Gassackmodul (10) zur Verwendung in einer Fahrzeuginsassen-Rückhalteeinrichtung mit einem aus Kunststoff gebildeten Generatorträger (12), **dadurch gekennzeichnet, daß** auf dem Generatorträger (12) eine durch Abscheiden von Metall gebildete gedruckte Schaltung (24) mit einem Kontaktabschnitt (30) vorgesehen ist und die gedruckte Schaltung (24) zur Auslösung eines elektrischen Funktionselements mit einem in einem vorbestimmten Abstand zu dem Kontaktabschnitt (30) angeordneten Schaltelement (44) zusammenwirkt.

10. Gassackmodul nach Anspruch 9, **dadurch gekennzeichnet, daß** das Schaltelement (44) einen Gegenkontakt für den Kontaktabschnitt (30) bildet.

11. Gassackmodul nach Anspruch 9 oder 10, **dadurch gekennzeichnet, daß** der Kontaktabschnitt (30) durch zwei benachbarte und elektrisch voneinander isolierte Abschnitte der gedruckten Schaltung (24) gebildet ist, die zur Auslösung des elektrischen Funktionselements durch das Schaltelement (44) überbrückbar sind.

12. Gassackmodul nach einem der Ansprüche 1 bis 11, **dadurch gekennzeichnet, daß** das elektrische Funktionselement eine Hupe ist.

13. Gassackmodul nach einem der Ansprüche 1 bis 12, **dadurch gekennzeichnet, daß** die gedruckte Schaltung (24) an eine Steckverbindung (50) zur Verbindung der gedruckten Schaltung (24) mit einer Fahrzeugelektronik angeschlossen ist.

14. Gassackmodul nach einem der Ansprüche 1 bis 13, **dadurch gekennzeichnet, daß** der Generatorträger (12) aus einer thermoplastischen Kunststoffmatrix mit einem in die Kunststoffmatrix eingebetteten Metallkomplex gebildet ist.

15. Gassackmodul nach Anspruch 14, **dadurch gekennzeichnet, daß** die thermoplastische Kunststoffmatrix aus der aus Polyamid, Polyethylenterephthalat, Polybutylenterephthalat, Acrylnitril-Butadien-Styrol, Polypropylen, Polycarbonat und Polyetherimid bestehenden Gruppe ausgewählt ist.

16. Gassackmodul nach einem der Ansprüche 1 bis 15, **dadurch gekennzeichnet, daß** die gedruckte Schaltung (24) metallisierte Durchgangslöcher aufweist.

17. Gassackmodul nach einem der Ansprüche 1 bis 16, **dadurch gekennzeichnet, daß** die gedruckte Schaltung (24) durch Laserstrukturieren einer Oberfläche des Generatorträgers (12) und Abscheiden von Metall auf der strukturierten Oberfläche erhältlich ist.

18. Gassackmodul nach einem der Ansprüche 1 bis 17, **dadurch gekennzeichnet, daß** das Abscheiden von Metall eine außenstromlose Metallabscheidung und/oder eine elektrolytische Metallabscheidung umfaßt.

19. Verfahren zur Herstellung eines Gassackmoduls (10) für eine Fahrzeuginsassen-Rückhalteeinrichtung, wobei das Gassackmodul (10) einen aus Kunststoff gebildeten Generatorträger (12) und ein auf einem Abschnitt (22) des Generatorträgers (12) angeordnetes Schaltelement (28) aufweist, und wobei das Verfahren die folgenden Schritte umfaßt:
Vorbehandeln einer Oberfläche des Generatorträgers (12) aus Kunststoff in einem vorbestimmten Bereich zur Erzeugung einer Oberflächenrauhigkeit und
Elektrolytisches Abscheiden von Metall auf der vorbehandelten Oberfläche unter Bildung einer gedruckten Schaltung (24), die zur Auslösung eines elektrischen Funktionselements mit dem Schaltelement (28) zusammenwirkt.

20. Verfahren nach Anspruch 19, **dadurch gekennzeichnet, daß** der Generatorträger (12) durch Spritzgießen aus einem thermoplastischen Kunststoff mit einem in den Kunststoff eingebetteten Metallkomplex hergestellt wird.

21. Verfahren nach Anspruch 19 oder 20, **dadurch gekennzeichnet, daß** das Vorbehandeln ein bildmäßiges Belichten mit einem Laser umfaßt.

22. Verfahren nach Anspruch 19, **dadurch gekennzeichnet, daß** das Vorbehandeln ein chemisches Ätzen oder ein Plasmaätzen umfaßt und daß vor dem elektrolytischen Abscheiden von Metall eine außenstromlose Metallabscheidung durchgeführt wird.
